# EUROPEAN PATENT APPLICATION

(11) **EP 4 782 380 A1**
(43) Date of publication of application: **29.07.2026**
(21) Application number: 25748278.6
(22) Date of filing: 22.01.2025
(51) Int. Cl.: B65H 75/10, B29B 11/16, D03D 1/00, D03D 15/267, H05K 1/03, B29K 105/10

(54) **ROLLED GLASS CLOTH**

(30) Priority: 02.02.2024 JP 2024014782
(71) Applicant: Nitto Boseki Co., Ltd., Fukushima-shi, Fukushima 960-8161 (JP)
(72) Inventor: URABAYASHI, Yuhei, Fukushima-shi, Fukushima 960-2154 (JP); IKEJIRI, Hirotaka, Fukushima-shi, Fukushima 960-2154 (JP); USAMI, Hiroki, Fukushima-shi, Fukushima 960-2154 (JP); KANNO, Naoto, Fukushima-shi, Fukushima 960-2154 (JP)
(74) Representative: Schön, Christoph
(86) International application number: PCT/JP2025/001927
(87) International publication number: WO 2025/164470

(57) **Abstract**

A rolled glass cloth is provided in which rippling buckling in an elongated glass cloth does not occur even when unwound under a strong tension of approximately 15 kgf. In a rolled glass cloth 1 according to the present invention, an elongated glass cloth 3 using glass fibers constituted of a plurality of glass filaments as warp yarns and weft yarns is wound around a core tube 2 in a length direction thereof. A difference between a maximum value and a minimum value of roll hardness in each of 0°-, 90°-, 180°-, and 270°-directions relative to a vertical direction in a middle layer 4 of the rolled glass cloth 1, where 50% of an entire length of the elongated glass cloth 3 in the length direction is wound around the core tube 2, is 2.9 or less.

## Description

### Technical Field

The present invention relates to a rolled glass cloth.

### Background Art

Generally, glass cloths used for printed wiring boards and the like are distributed in the form of rolled glass cloths in which an elongated glass cloth is wound around a core tube. As the rolled glass cloth, conventionally, a rolled elongated glass cloth with a thickness of 8 µm or more and 100 µm or less, a roll hardness of 45 or more and 70 or less, and a width shrinkage of -0.5% or more and less than 0.1% is known (for example, refer to Patent Literature 1).

With the rolled elongated glass cloth described in Patent Literature 1, a glass cloth can be provided which has superior roll quality with reduced distortion in its weave structure such as wrinkles even when the modulus of elasticity of the glass cloth is low and which has a small variation in dimensional changes during the manufacturing process of a printed wiring board.

### Citation List

### Patent Literature

Patent Literature 1: Japanese Patent Laid-Open No. 2021-11340

### Summary of Invention

### Technical Problem

However, even if no distortion of the weave structure such as wrinkles occurs when an elongated glass cloth is wound around a core tube or unwound with a weak tension of less than 15 kgf as is the case of the rolled elongated glass cloth described in Patent Literature 1, a disadvantage occurs when unwinding the elongated glass cloth with a strong tension of approximately 15 kgf in that a compressive force is generated in a width direction of the elongated glass cloth due to the Poisson effect and the compressive force causes rippling buckling (deformation) in the width direction of the elongated glass cloth.

The Poisson effect refers to a phenomenon where, when a uniaxial stress acts on an object in a z-axis direction thereof and causes a longitudinal strain εz to occur as the z-axis dimension of the object elongates according to the elasticity of the object, transverse strains εx and εy also occur incidentally in x-axis and y-axis directions perpendicular to the z-axis, respectively.

An object of the present invention is to eliminate the disadvantage and provide a rolled glass cloth in which rippling buckling in a width direction of the elongated glass cloth does not occur even when unwound under a strong tension of approximately 15 kgf.

### Solution to Problem

To achieve the object described above, the rolled glass cloth according to the present invention is a rolled glass cloth in which an elongated glass cloth using glass fibers constituted of a plurality of glass filaments as warp yarns and weft yarns is wound around a core tube in a length direction thereof, wherein a difference between a maximum value and a minimum value of roll hardness in each of 0°-, 90°-, 180°-, and 270°-directions relative to a vertical direction in a middle layer of the rolled glass cloth, where 50% of an entire length of the elongated glass cloth in the length direction is wound around the core tube, is 2.9 or less.

With the rolled glass cloth of the present invention, due to the difference between the maximum value and the minimum value of the roll hardness in the middle layer of the rolled glass cloth in each of 0°-, 90°-, 180°-, and 270°-directions relative to the vertical direction being 2.9 or less, rippling buckling can be prevented from occurring in the width direction of the elongated glass cloth even when unwound under a strong tension of approximately 15 kgf.

In addition, in the rolled glass cloth according to the present invention, preferably, a roll hardness on a surface layer of the rolled glass cloth in which an entire length of the elongated glass cloth in the length direction is wound around the core tube is more than 70.

Furthermore, a prepreg according to the present invention includes at least a portion of the elongated glass cloth constituting the rolled glass cloth according to the present invention, and a printed wiring board according to the present invention includes at least a portion of the elongated glass cloth constituting the rolled glass cloth according to the present invention. In this case, at least a portion of the elongated glass cloth may be glass cloth that has been unwound from the rolled glass cloth according to the present invention.

### Brief Description of Drawings

FIG. 1 is a front view showing a rolled glass cloth according to the present invention.
FIG. 2 is a sectional view taken along line II-II in FIG. 1.

### Description of Embodiment

Next, an embodiment of the present invention will be described in greater detail with reference to the accompanying drawings.

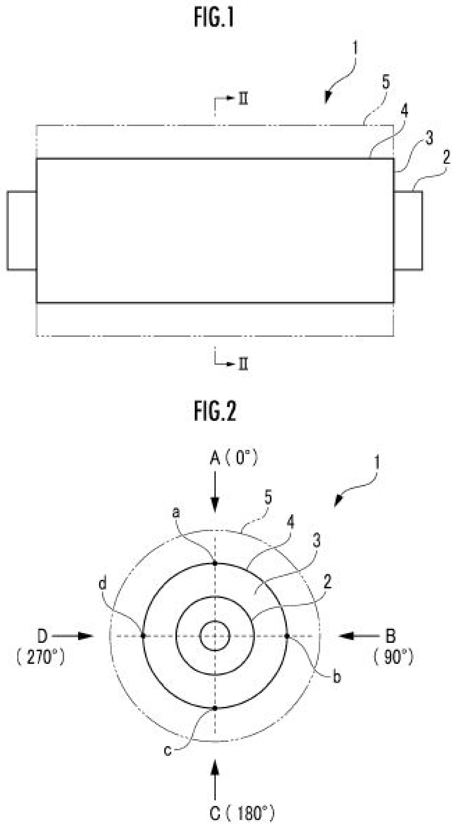

As shown in FIGS. 1 and 2, a rolled glass cloth 1 according to the present embodiment comprises a core tube 2 at a center portion thereof, with an elongated glass cloth 3 wound around the core tube 2 in a length direction thereof. The elongated glass cloth 3 is woven using glass fibers constituted of a plurality of glass filaments as warp yams and weft yarns and has, for example, a width ranging from 500 to 2000 mm, a thickness ranging from 6 to 200 µm, and a length ranging from 200 to 5000 m.

The width of the elongated glass cloth 3 preferably ranges from 800 to 1600 mm and more preferably ranges from 1000 to 1400 mm.

From the perspective of reducing the likelihood of an occurrence of unwinding or rippling buckling, the thickness of the elongated glass cloth 3 preferably ranges from 8 to 80 µm and more preferably ranges from 9 to 14 µm.

The length of the elongated glass cloth 3 preferably ranges from 500 to 2500 m and more preferably ranges from 800 to 1300 m. When the length of the elongated glass cloth 3 is within this range, an effect of reducing rippling buckling can be sufficiently produced.

In the rolled glass cloth 1, a difference between a maximum value and a minimum value of roll hardness in each of 0°-, 90°-, 180°-, and 270°-directions relative to a vertical direction (directions A to D indicated by arrows in FIG. 2) in a middle layer 4, where 50% of an entire length L of the elongated glass cloth 3 in the length direction is wound around the core tube 2, is 2.9 or less. In other words, as indicated by imaginary lines in FIG. 2, the middle layer 4 represents a state where a length corresponding to 0.5L has been unwound from a surface layer 5 in a state where the entire length L of the elongated glass cloth 3 in the length direction is wound around the core tube 2.

The roll hardness in the middle layer 4 can be measured as follows. First, as shown in FIG. 2, the roll hardness in the 0°-direction relative to the vertical direction is measured by pressing a rubber hardness tester (manufactured by Kobunshi Keiki Co., Ltd., product name: Asker Durometer Type C) against a location "a" corresponding to the 0°-direction A relative to the vertical direction in the middle layer 4 of the rolled glass cloth 1 from the direction A. At this point, specifically, in the width direction including the location "a" of the rolled glass cloth 1, the roll hardness is measured at a plurality of locations spaced 10 cm apart from a location 5 cm inward from one end portion to a location 5 cm inward from another end portion or a location between less than 15 cm and 5 cm or more inward from the other end portion of the rolled glass cloth 1 in the width direction, and an average value of the measured roll hardness is adopted as the roll hardness in the 0°-direction relative to the vertical direction.

Next, the rolled glass cloth 1 is rotated by 90° toward the left in FIG. 2 and unwound by one-quarter of a circumferential length in the middle layer 4, a location "b" corresponding to a direction B shown in FIG. 2 is moved to a location corresponding to the location "a", and the roll hardness in the 90°-direction relative to the vertical direction is measured by performing a similar operation to the measurement of the roll hardness in the 0°-direction relative to the vertical direction.

Subsequently, in a similar manner, the rolled glass cloth 1 is further rotated by 90° (total of 180°) toward the left in FIG. 2 and further unwound by one-quarter (total of one-half) of the circumferential length in the middle layer 4, a location "c" corresponding to a direction C shown in FIG. 2 is moved to the location corresponding to the location "a", the roll hardness in the 180°-direction relative to the vertical direction is measured, the rolled glass cloth 1 is further rotated by 90° (total of 270°) toward the left in FIG. 2 and further unwound by one-quarter (total of three-quarters) of the circumferential length in the middle layer 4, a location "d" corresponding to a direction D shown in FIG. 2 is moved to the location corresponding to the location "a", and the roll hardness in the 270°-direction relative to the vertical direction is measured.

From the perspective of further suppressing the occurrence of rippling buckling, the difference between the maximum value and the minimum value of roll hardness in each of 0°-, 90°-, 180°-, and 270°-directions relative to the vertical direction (directions A to D indicated by arrows in FIG. 2) in the middle layer 4 of the rolled glass cloth 1 is more preferably 1.0 or less.

In addition, from the perspective of a lower likelihood of unwinding of the rolled glass cloth 1, the average value of the roll hardness in each of 0°-, 90°-, 180°-, and 270°-directions relative to the vertical direction in the middle layer 4 of the rolled glass cloth 1 is preferably in the range of 62.0 or more, more preferably in the range of more than 70.0, and even more preferably in the range of 71.4 or more. Unwinding refers to a phenomenon where, during the winding of the elongated glass cloth 3 around the core tube 2 or during transport of the rolled glass cloth 1 having been wound around the core tube 2, external disturbances cause slippage to occur between layers of the wound elongated glass cloth 3 along an axial direction of the core tube 2, resulting in an end face of the wound rolled glass cloth 1 deforming into a frustoconical shape.

Furthermore, from the perspective of a lower likelihood of unwinding of the rolled glass cloth 1, the roll hardness on the surface layer 5 in a state where the entire length L of the elongated glass cloth 3 in the length direction is wound around the core tube 2 is preferably in the range of 62.0 or more, more preferably in the range of 68.4 or more, even more preferably in the range of more than 70.0, and particularly preferably in the range of 71.4 or more. The roll hardness on the surface layer 5 can be determined by measuring the roll hardness in each of 0°-, 90°-, 180°-, and 270°-directions relative to the vertical direction and calculating an average value of the roll hardness in each direction by performing a similar operation to the measurement of the roll hardness in the middle layer 4 in a state where the entire length L of the elongated glass cloth 3 in the length direction is wound around the core tube 2.

The rolled glass cloth 1 according to the present embodiment can be, for example, manufactured as follows.

First, glass filaments are obtained by melting and fiberizing a predetermined glass batch (raw glass material). While a filament diameter of the glass filaments is not particularly limited, for printed wiring board applications, the filament diameter is preferably 10 µm or less, more preferably 8 µm or less, and particularly preferably ranges from 3 to 5 µm.

The glass filaments are bundled into glass fibers using known methods, typically in quantities that range from, for example, 25 to 500 strands and preferably 40 to 300 strands. The process of melting and fiberizing a glass batch to obtain glass filaments and, subsequently, bundling a plurality of the glass filaments to obtain glass fibers is called spinning.

While a glass composition of the glass fibers is not particularly limited, examples include the E glass composition being the most versatile glass composition, a high-strength, high-modulus glass composition, a high-modulus, easy-to-manufacture glass composition, a low-dielectric constant, low-dielectric loss tangent glass composition, and a low-thermal expansion, low-dielectric constant glass composition.

The E glass composition is a composition containing 52.0 to 56.0 mass% of SiO₂, 12.0 to 16.0 mass% of Al₂O₃, 20.0 to 25.0 mass% in total of MgO and CaO, and 5.0 to 10.0 mass% of B₂O₃, based on the total amount of glass fibers.

The high-strength, high-modulus glass composition is a composition containing 60.0 to 70.0 mass% of SiO₂, 20.0 to 30.0 mass% of Al₂O₃, 5.0 to 15.0 mass% of MgO, 0 to 1.5 mass% of Fe₂O₃, and 0 to 0.2 mass% in total of Na₂O, K₂O, and Li₂O, based on the total amount of glass fibers. Preferably, the high-strength, high-modulus glass composition is a composition containing 0.15 to 1.50 mass% of Fe₂O₃, 0.01 to 0.10 mass% of ZrO₂, and 0.02 to 0.20 mass% in total of Na₂O, K₂O, and Li₂O.

The high-modulus, easy-to-manufacture glass composition is a composition containing 57.0 to 60.0 mass% of SiO₂, 17.5 to 20.0 mass% of Al₂O₃, 8.5 to 12.0 mass% of MgO, 10.0 to 13.0 mass% of CaO, and 0.5 to 1.5 mass% of B₂O₃, based on the total amount of glass fibers, provided that the total amount of SiO₂, Al₂O₃, MgO, and CaO is 98.0 mass% or more.

The low-dielectric constant, low-dielectric loss tangent glass composition is a composition containing 48.0 to 62.0 mass% of SiO₂, 17.0 to 26.0 mass% of B₂O₃, 9.0 to 18.0 mass% of Al₂O₃, 0.1 to 9.0 mass% of CaO, 0 to 6.0 mass% of MgO, 0 to 0.5 mass% in total of Na₂O, K₂O, and Li₂O, 0 to 5.0 mass% of TiO₂, 0 to 6.0 mass% of SrO, 0 to 3.0 mass% in total of F₂ and Cl₂, and 0 to 6.0 mass% of P₂O₅, based on the total amount of glass fibers.

The low-thermal expansion, low-dielectric constant glass composition is a composition containing 42.0 to 63.0 mass% of SiO₂, 19.0 to 27.3 mass% of Al₂O₃, more than 3.00 mass% and 13.00 mass% or less of ZnO, 6.50 to 19.0 mass% of P₂O₅, 0.00 to 7.00 mass% of MgO, and 1.00 mass% or less in total of Li₂O, Na₂O, and K₂O, based on the total amount of glass fibers.

A measurement of a content of each component in the glass compositions described above can be performed using an ICP emission spectrometer for the light element Li and using a wavelength-dispersive X-ray fluorescence spectrometer for the other elements. Specifically, the measurement of the content of each component in the glass compositions can be performed as follows.

First, after a glass cloth cut to an appropriate size is placed in a platinum crucible, the cut glass cloth is melted in an electric furnace for 6 hours at a temperature of 1400 to 1650°C while stirring to obtain a homogeneous molten glass. If organic matter adheres to the glass cloth surface or if the glass fibers are primarily included as reinforcing material in organic matter (resin), the organic matter is removed by, for example, heating in a muffle furnace at 300 to 650°C for around 2 to 24 hours before use.

Next, the obtained molten glass is poured onto a carbon plate to form glass cullet, which is then crushed and pulverized to produce glass powder. For the light element Li, the glass powder is heated and decomposed with acid and then quantitatively analyzed using an ICP emission spectrometer. For the other elements, the glass powder is molded into a disk shape with a press and then quantitatively analyzed using a wavelength-dispersive X-ray fluorescence spectrometer.

First, the fundamental parameter method is used to measure the content of each component in a measurement sample. Next, based on a measurement result, at least three calibration curve samples are prepared and analyzed using the calibration curve method. The content of each component in the calibration curve samples can be quantitatively analyzed using, for example, an ICP emission spectrometer.

Next, results of the quantitative analyses are converted to oxide equivalents to calculate the content of each component and the total amount, and the content (mass%) of each component described above can be determined from the numerical values.

While the modulus of elasticity of the glass fibers constituting the glass filaments are not particularly limited, for example, the modulus of elasticity ranges from 40 to 120 GPa. Conventionally, since unwinding and rippling buckling are likely to occur, the modulus of elasticity preferably ranges from 45 to 70 GPa and more preferably ranges from 62 to 68 GPa from the perspective of the effects produced by the present invention being more pronounced. In addition, while a strength of the glass fibers constituting the glass filaments are not particularly limited, for example, the strength ranges from 1.5 to 6.0 GPa and more preferably ranges from 2.0 to 4.5 GPa.

The modulus of elasticity and the strength of the glass fibers constituting the glass filaments can be measured using methods described in the examples presented later.

A mass per unit length of the glass fibers, for example, preferably ranges from 0.6 to 135 g/1000 m, more preferably ranges from 0.7 to 25 g/1000 m, and from the perspective of reducing the likelihood of unwinding and rippling buckling, even more preferably ranges from 0.8 to 3.8 g/1000 m and particularly preferably ranges from 0.9 to 1.4 g/1000 m.

Next, the elongated glass cloth 3 can be obtained by weaving the glass fibers as warp yarns or weft yarns using known looms. Examples of the looms include air-jet or water-jet looms, shuttle looms, and rapier looms. In addition, examples of weaving methods using the looms include plain weave, satin weave, basket weave, and twill weave, and from the perspective of manufacture efficiency, plain weave is preferably used. While a weave density of the glass fiber yarns during weaving is not particularly limited, for example, the weave density preferably ranges from 10 to 150 yarns/25 mm and more preferably ranges from 40 to 100 yarns/25 mm.

During weaving, a sizing agent may be used to bundle the glass filaments and protect the glass fibers. Examples of the sizing agent include sizing agents with a starchbased or PVA (polyvinyl alcohol)-based film-forming component. The sizing agents may contain an oil agent or a softener.

An amount of adhesion of the sizing agent to the glass cloth relative to, for example, 100 parts by mass of the glass fiber yarn preferably ranges from 0.1 to 3 parts by mass and more preferably ranges from 0.5 to 1.5 parts by mass.

After weaving, the elongated glass cloth 3 may be subjected to deoiling, surface treatment, and fiber opening.

As the deoiling, a treatment can be performed which involves placing the elongated glass cloth 3 in a heating furnace at an ambient temperature of 350°C to 400°C for 40 to 80 hours to thermally decompose organic matter adhering to the glass fibers.

As the surface treatment, a treatment can be performed which involves immersing the glass cloth in a solution containing a silane coupling agent or containing the silane coupling agent and a surfactant, squeezing out excess water, and then heat-drying at a temperature of 80 to 180°C for 0.2 to 30 minutes or preferably 1 to 30 minutes.

Examples of the silane coupling agent include aminosilanes, ureido silanes, chlorosilanes, epoxysilanes, mercaptosilanes, vinylsilanes, (meth)acrylsilanes, phenylsilanes, styrylsilanes, and isocyanate silanes. In the present embodiment, the silane coupling agents may be used singly or in combinations of two or more thereof.

Examples of aminosilanes include γ-aminopropyltriethoxysilane, N-β-(aminoethyl)-γ-aminopropyltrimethoxysilane, N-β-(aminoethyl)-N'-β-(aminoethyl)-γ-aminopropyltrimethoxysilane, and γ-anilino-propyltrimethoxysilane.

Examples of ureido silanes include γ-ureidopropyl triethoxysilane.

Examples of chlorosilanes include γ-chloropropyl trimethoxysilane.

Examples of epoxysilanes include β-(3,4-epoxycyclohexyl)ethyltrimethoxysilane and γ-glycidoxypropyltrimethoxysilane.

Examples of mercaptosilanes include γ-mercaptotrimethoxysilane and γ-mercaptopropyltrimethoxysilane.

Examples of vinylsilanes include vinyltrimethoxysilane, N-β-(N-vinylbenzylaminoethyl)-γ-aminopropyltrimethoxysilane, and N-benzyl-β-aminoethyl-γ-aminopropyltrimethoxysilane.

Examples of (meth)acrylsilanes include γ-acryloxypropyltrimethoxysilane and γ-methacryloxypropyltrimethoxysilane.

Examples of phenylsilanes include phenyl trimethoxysilane.

Examples of styrylsilanes include p-styryltrimethoxysilane.

Examples of isocyanate silanes include γ-isocyanatopropyl triethoxysilane.

In addition, examples of the surfactant include nonionic surfactants, cationic surfactants, anionic surfactants, and amphoteric surfactants. In the present embodiment, the surfactants may be used singly or in combinations of two or more thereof.

Examples of the nonionic surfactants include ethylene oxide-propylene oxide alkyl ethers, polyoxyethylene alkyl ethers, polyoxyethylene-polyoxypropylene block copolymers, alkyl polyoxyethylene-polyoxypropylene block copolymer ethers, polyoxyethylene fatty acid esters, polyoxyethylene fatty acid monoesters, polyoxyethylene fatty acid diesters, polyoxyethylene sorbitan fatty acid esters, glycerol fatty acid ester ethylene oxide adducts, polyoxyethylene castor oil ethers, hardened castor oil ethylene oxide adducts, alkylamine ethylene oxide adducts, fatty acid amide ethylene oxide adducts, glycerol fatty acid esters, polyglyceryl fatty acid esters, pentaerythritol fatty acid esters, sorbitol fatty acid esters, sorbitan fatty acid esters, sucrose fatty acid esters, polyhydric alcohol alkyl ethers, fatty acid alkanolamide, acetylene glycol, acetylene alcohol, ethylene oxide adducts of acetylene glycol, and ethylene oxide adducts of acetylene alcohol.

Examples of the cationic surfactants include alkyl dimethyl benzylammonium chloride, alkyl trimethyl ammonium chloride, alkyl dimethyl ethyl ammonium ethyl sulfate, higher alkylamine salts (acetate, hydrochloride, and the like), ethylene oxide adducts of higher alkylamines, condensation products of higher fatty acids with polyalkylene polyamines, salts of esters of higher fatty acids with alkanolamines, salts of higher fatty acid amides, imidazoline-type cationic surfactants, and alkylpyridinium salts.

Examples of anionic surfactants include higher alcohol sulfate ester salts, higher alkyl ether sulfate ester salts, α-olefin sulfate ester salts, alkylbenzenesulfonate salts, α-olefin sulfonate salts, reaction products of fatty acid halides with N-methyltaurine, sulfosuccinic acid dialkyl ester salts, higher alcohol phosphate ester salts, and phosphate ester salts of higher alcohol ethylene oxide adducts.

Examples of amphoteric surfactants include amino acid-type amphoteric surfactants such as alkylaminopropionic acid alkali metal salts, betaine-type amphoteric surfactants such as alkyl dimethyl betaine, and imidazoline-type amphoteric surfactants.

As the fiber opening, for example, a treatment can be performed which involves widening a yarn width of both warp yarns and weft yarns by applying a tension of 20 to 200 N to the warp yarns of the elongated glass cloth 3 while performing fiber opening using water flow pressure, fiber opening using high-frequency vibration with a liquid medium, fiber opening using the pressure of a fluid with surface pressure, or fiber opening using pressure applied by a roll.

Next, by winding the woven elongated glass cloth 3 around the core tube 2 at a predetermined winding tension, the rolled glass cloth 1 in which the elongated glass cloth 3 is wound around the core tube 2 in the length direction thereof can be obtained.

At the start of winding, the winding tension preferably ranges from 3 to 60 kgf, more preferably ranges from 5 to 55 kgf, and even more preferably ranges from 10 to 30 kgf. Due to the winding tension being 3 kgf or more at the start of winding, the average value of roll hardness can be increased to reduce the likelihood of unwinding, and due to the winding tension being 60 kgf or less, the elongated glass cloth 3 can be wound while suppressing the occurrence of creasing caused by excessive tension during winding.

In addition, at the end of winding, the winding tension preferably ranges from 3 to 60 kgf, more preferably ranges from 5 to 55 kgf, and even more preferably ranges from 10 to 30 kgf. Due to the winding tension being 3 kgf or more at the end of winding, the average value of roll hardness can be increased to reduce the likelihood of unwinding, and due to the winding tension being 60 kgf or less, the elongated glass cloth 3 can be wound while suppressing the occurrence of creasing caused by excessive tension during winding.

When winding the elongated glass cloth 3 around the core tube 2, by winding the elongated glass cloth 3 while pressing the elongated glass cloth 3 against the core tube 2 with a plurality of press rollers at positions separated from each other so that the winding tensions at the start of winding and at the end of winding are in the ranges described above, respectively, the difference between the maximum value and the minimum value of the roll hardness in the middle layer 4 of the rolled glass cloth 1 in each of 0°-, 90°-, 180°-, and 270°-directions relative to the vertical direction can be made 2.9 or less.

Winding the elongated glass cloth 3 while pressing the elongated glass cloth 3 against the core tube 2 with the plurality of press rollers prevents localized slacking of the rolled glass cloth 1 caused by temporary insufficient pressure when the press roller retracts as the rolled glass cloth 1 becomes thicker (increases in diameter), and reduces the difference between the maximum value and the minimum value of the roll hardness in the middle layer 4 of the rolled glass cloth 1 in each of 0°-, 90°-, 180°-, and 270°-directions relative to the vertical direction to 2.9 or less. Winding the elongated glass cloth 3 while pressing the elongated glass cloth 3 against the core tube 2 using only one of the press rollers disadvantageously causes localized slacking of the rolled glass cloth 1 due to temporary insufficient pressure when the press roller retracts as the rolled glass cloth 1 becomes thicker and causes rippling buckling.

When using the plurality of press rollers, pressure applied by each press roller preferably ranges from 1 to 80 kgf and more preferably ranges from 2 to 65 kgf. Due to the pressure applied by each press roller being 1 kgf or more, the average value of roll hardness can be increased to reduce the likelihood of unwinding, and due to the pressure applied by each press roller being 80 kgf or less, a defect that wrinkles form on the surface of the elongated glass cloth 3 when crushed by the press rollers while the elongated glass cloth 3 is still sagging during winding can be resolved.

A prepreg according to the present embodiment includes at least a portion of the elongated glass cloth 3 constituting the rolled glass cloth 1 according to the present invention described above. At least a portion of the elongated glass cloth 3 may be glass cloth that has been unwound from the rolled glass cloth 1 according to the present embodiment.

The prepreg according to the present embodiment can be obtained by impregnating at least a portion of the elongated glass cloth 3 constituting the rolled glass cloth 1 according to the present embodiment with resin and semi-curing the portion impregnated by a known method.

In the prepreg according to the present embodiment, the resin impregnated into at least a portion of the elongated glass cloth 3 is not particularly limited. Examples of the resin include epoxy resins, phenolic resins, unsaturated polyester resins, melamine resins, modified polyimide resins, polyamide resins, polyimide resins, polybutylene terephthalate resins, polyethylene terephthalate resins, polyphenylene sulfide resins, polyphenylene ether resins, modified polyphenylene ether resins, and fluororesins.

A printed wiring board according to the present embodiment includes at least a portion of the elongated glass cloth 3 constituting the rolled glass cloth 1 according to the present invention described above. At least a portion of the elongated glass cloth 3 may be glass cloth that has been unwound from the rolled glass cloth 1 according to the present embodiment.

The printed wiring board according to the present embodiment can be obtained by, for example, curing the prepreg according to the present embodiment described above.

Next, examples and comparative examples of the present invention will be described.

### Examples

### (Examples 1 to 5 and Comparative Example 1)

First, after weaving glass cloths which are made of glass filaments having the glass compositions shown in Table 1 and which correspond to the cloth types defined in the IPC standard shown in Table 1, the glass cloths were subjected to deoiling, surface treatment, and fiber opening to obtain the elongated glass cloths 3 according to Examples 1 to 5 and Comparative Example 1 with a width of 1270 mm and a length of 1000 m.

Among the cloth types defined in the IPC standard shown in Table 1, "1078" is a glass cloth whose specifications include: yarn used: D500 (filament diameter 5.0 µm, yarn weight 10.2 g/1000 m); warp yarn weave density: 53 yarns/25 mm; weft yarn weave density: 53 yarns/25 mm; thickness: 44 µm; and mass per unit area: 43 g/m², "1010" is a glass cloth whose specifications include: yarn used: filament diameter 4.0 µm, yarn weight 1.32 g/1000 m); warp yarn weave density: 95 yarns/25 mm; weft yarn weave density: 95 yarns/25 mm; thickness: 13 µm; and mass per unit area: 9.9 g/m², and "1006" is a glass cloth whose specifications include: yarn used: yarn formed by bundling 38 glass filaments with a diameter of 3.6 µm; warp yarn weave density: 105 yarns/25 mm; weft yarn weave density: 110 yarns/25 mm; and thickness: 10 µm.

The 1006-type glass cloth made from glass filaments of composition A used yarns with a yarn weight of 0.89 g/1000 m, and the glass cloth had a mass per unit area of 7.5 g/m². In addition, the 1006-type glass cloth made from glass filaments of composition B used yarns with a weight of 0.99 g/1000 m, and the glass cloth had a mass per unit area of 8.6 g/m².

Next, each of the elongated glass cloths 3 obtained in the respective examples and the Comparative Example 1 was treated under manufacturing conditions shown in Table 1 to produce the rolled glass cloths 1 according to Examples 1 to 5 and Comparative Example 1.

Next, the roll hardness in the middle layer 4 or the surface layer 5 of the rolled glass cloth 1 was measured using the method described below, and the rippling buckling in the width direction of the elongated glass cloth 3 and the unwinding of the rolled glass cloth 1 were evaluated. Table 1 shows results of the evaluation. In Table 1, the roll hardness of the surface layer 5 of the rolled glass cloth 1 is described as "average" and the rippling buckling is described as "rippling".

In addition, Table 2 shows details of glass composition A and glass composition B shown in Table 1 as well as a dielectric constant, a coefficient of linear expansion, a tensile strength, and a tensile modulus of elasticity of glass filaments with each glass composition.

### (Roll Hardness in Middle Layer)

As shown in FIG. 2, the roll hardness in the 0°-direction relative to the vertical direction is measured by pressing a rubber hardness tester (manufactured by Kobunshi Keiki Co., Ltd., product name: Asker Durometer Type C) against a location "a" corresponding to the 0°-direction A relative to the vertical direction in the middle layer 4 of the rolled glass cloth 1 from the direction A. At this point, specifically, in the width direction including the location "a" of the rolled glass cloth 1, the roll hardness was measured at a plurality of locations spaced 10 cm apart from a location 5 cm inward from one end portion to a location 5 cm inward from another end portion of the rolled glass cloth 1 in the width direction, and an average value of the measured roll hardness was adopted as the roll hardness in the 0°-direction relative to the vertical direction.

Next, the rolled glass cloth 1 was rotated by 90° toward the left in FIG. 2 and unwound by one-quarter of a circumferential length in the middle layer 4, a location "b" corresponding to a direction B shown in FIG. 2 was moved to a location corresponding to the location "a", and the roll hardness in the 90°-direction relative to the vertical direction was measured by performing a similar operation to the measurement of the roll hardness in the 0°-direction relative to the vertical direction.

Subsequently, in a similar manner, the rolled glass cloth 1 was further rotated by 90° (total of 180°) toward the left in FIG. 2 and further unwound by one-quarter (total of one-half) of the circumferential length in the middle layer 4, a location "c" corresponding to a direction C shown in FIG. 2 was moved to the location corresponding to the location "a", the roll hardness in the 180°-direction relative to the vertical direction was measured, the rolled glass cloth 1 was further rotated by 90° (total of 270°) toward the left in FIG. 2 and further unwound by one-quarter (total of three-quarters) of the circumferential length in the middle layer 4, a location "d" corresponding to a direction D shown in FIG. 2 was moved to the location corresponding to the location "a", and the roll hardness in the 270°-direction relative to the vertical direction was measured.

In addition, an average value of roll hardness in the 0°-, 90°-, 180°-, and 270°-directions relative to the vertical direction was adopted as an average of roll hardness in the middle layer, and a difference between the maximum value and the minimum value of roll hardness in each of the 0°-, 90°-, 180°-, and 270°-directions relative to the vertical direction was determined from the maximum value and the minimum value of roll hardness in each of the 0°-, 90°-, 180°-, and 270°-directions relative to the vertical direction.

In Table 1, the difference between the maximum value and the minimum value of roll hardness in each of the 0°-, 90°-, 180°-, and 270°-directions relative to the vertical direction is described as "maximum-minimum difference at 0°, 90°, 180°, and 270°".

In addition, a coefficient of variation of values of roll hardness measured at a plurality of locations spaced 10 cm apart from a location 5 cm inward from one end portion to a location 5 cm inward from the other end portion of the rolled glass cloth 1 in the width direction when measuring the roll hardness in the 0°-direction relative to the vertical direction was adopted as a coefficient of variation of the roll hardness in the weft yarn direction.

### (Roll Hardness in Surface Layer)

As indicated by imaginary lines in FIG. 2, the roll hardness in the surface layer 5 was determined by measuring the roll hardness in each of 0°-, 90°-, 180°-, and 270°-directions relative to the vertical direction and calculating an average value of the roll hardness in each direction by performing a similar operation to the measurement of the roll hardness in the middle layer 4 with respect to the surface layer 5 in a state where the entire length L of the elongated glass cloth 3 in the length direction is wound around the core tube 2.

In addition, a coefficient of variation of values of roll hardness measured at a plurality of locations spaced 10 cm apart from a location 5 cm inward from one end portion to a location 5 cm inward from the other end portion of the rolled glass cloth 1 in the width direction when measuring the roll hardness in the 0°-direction relative to the vertical direction was adopted as a coefficient of variation of the roll hardness in the weft yarn direction.

### (Rippling Buckling)

Rippling buckling was determined to have occurred if, when visually inspecting an appearance in the width direction of the elongated glass cloth 3 from the length direction while unwinding the rolled glass cloth 1 at a tension of 15 kgf, three or more rippling buckles with a height of 1 cm or more occur at intervals of 10 cm or less and, furthermore, the buckles occur continuously or intermittently over a length of 3 m or more in the length direction.

At this point, examples or comparative examples were evaluated as: "⊙" if no rippling buckling occurred along the entire length or within a range from the surface layer 5 to a location where 0.9L relative to the entire length L has been unwound; "O" if no rippling buckling occurred within a range from the surface layer 5 to a location where 0.5L relative to the entire length L has been unwound but rippling buckling occurred within a range from the location where 0.5L relative to the entire length L has been unwound to the location where 0.9L relative to the entire length L has been unwound; and "×" if rippling buckling occurred within a range from the surface layer 5 to the location where 0.5L relative to the entire length L has been unwound.

**(Table 1)**

| | | | Example 1 | Example 2 | Example 3 | Example 4 | Example 5 | Comparative Example 1 |
|---|---|---|---|---|---|---|---|---|
| Glass composition | | | Composition A | Composition A | Composition B | Composition A | Composition B | Composition A |
| Cloth type | | | 1078 | 1078 | 1010 | 1006 | 1006 | 1078 |
| Length (m) | | | 1000 | 1000 | 1000 | 1000 | 1000 | 1000 |
| Manufacturing conditions | | Tension (kgf) start of winding/end of winding | 11/4 | 8/4 | 6/4 | 6/4 | 6/4 | 9/5 |
| | | Number of press rollers | 2 | 2 | 2 | 2 | 2 | 1 |
| Roll hardness | Middle layer | Average | 73.2 | 74.4 | 72.3 | 72.6 | 72.5 | 73.0 |
| | | Maximum-minimum difference at 0°, 90°, 180°, and 270° | 0.5 | 1.5 | 2.0 | 2.5 | 2.5 | 4.2 |
| | | Coefficient of variation in weft yarn direction | 0.025 | 0.025 | 0.016 | 0.019 | 0.019 | 0.021 |
| | Surface layer | Average | 71.2 | 72.2 | 71.6 | 72.2 | 71.8 | 71.2 |
| | | Coefficient of variation in weft yarn direction | 0.013 | 0.019 | 0.010 | 0.015 | 0.015 | 0.014 |
| Rippling | | | ⊙ | ○ | ○ | ○ | ○ | × |
| Unwinding | | | ⊙ | ⊙ | ⊙ | ⊙ | ⊙ | ⊙ |

**(Table 2)**

| Glass composition | Composition A | Composition B |
|---|---|---|
| SiO₂ (mass%) | 54.5 | 65.0 |
| Al₂O₃ (mass%) | 14.6 | 25.0 |
| B₂O₃ (mass%) | 19.4 | 0.0 |
| MgO (mass%) | 4.2 | 9.5 |
| CaO (mass%) | 4.1 | 0.05 |
| TiO₂ (mass%) | 1.9 | 0.0 |
| F₂ (mass%) | 1.0 | 0.0 |
| Fe₂O₃ (mass%) | 0.1 | 0.3 |
| ZrO₂ (mass%) | 0.0 | 0.05 |
| Li₂O+Na₂O+K₂O (mass%) | 0.2 | 0.1 |
| Total (mass%) | 100.0 | 100.0 |
| Dielectric constant @1 GHz | 4.8 | - |
| Coefficient of linear expansion (ppm/K) | 3.3 | - |
| Tensile strength (GPa) | 3.0 | 4.8 |
| Tensile modulus of elasticity (GPa) | 66 | 88 |

Table 1 clearly shows that, with the rolled glass cloths 1 of Examples 1 to 5 of which the difference between the maximum value and the minimum value of roll hardness in each of 0°-, 90°-, 180°-, and 270°-directions relative to the vertical direction is 2.9 or less, the occurrence of rippling buckling can be prevented within a range from the surface layer 5 to a location where 0.5L relative to the entire length L has been unwound when unwinding with a tension of 15 kgf. On the other hand, Table 1 also clearly shows that, with the rolled glass cloth 1 of Comparative Example 1 of which the difference between the maximum value and the minimum value of roll hardness in each of 0°-, 90°-, 180°-, and 270°-directions relative to the vertical direction is more than 2.9, even if the coefficient of variation in the weft yarn direction of the roll hardness is equivalent to that of Examples 1 to 5, the occurrence of rippling buckling cannot be prevented within a range from the surface layer 5 to the location where 0.5L relative to the entire length L has been unwound when unwinding with a tension of 15 kgf.

### Reference Signs List

1 rolled glass cloth, 2 core tube, 3 elongated glass cloth, 4, middle layer, 5 surface layer.

## Claims

1. A rolled glass cloth in which an elongated glass cloth using glass fibers constituted of a plurality of glass filaments as warp yarns and weft yarns is wound around a core tube in a length direction thereof, wherein a difference between a maximum value and a minimum value of roll hardness in each of 0°-, 90°-, 180°-, and 270°-directions relative to a vertical direction in a middle layer of the rolled glass cloth, where 50% of an entire length of the elongated glass cloth in the length direction is wound around the core tube, is 2.9 or less.

2. The rolled glass cloth according to claim 1, wherein a roll hardness on a surface layer of the rolled glass cloth in which the entire length of the elongated glass cloth in the length direction is wound around the core tube is more than 70.

3. A prepreg, comprising at least a portion of the elongated glass cloth constituting the rolled glass cloth according to claim 1 or 2.

4. A printed wiring board, comprising at least a portion of the elongated glass cloth constituting the rolled glass cloth according to claim 1 or 2.
